# EUROPEAN PATENT SPECIFICATION

(11) **EP 3 863 390 B1**
(45) Date of publication and mention of the grant of the patent: **06.11.2024**
(21) Application number: 21155432.4
(22) Date of filing: 05.02.2021
(51) Int. Cl.: H05K 7/20

(54) **SELECTIVE RACK COOLING BASED ON EXTERNAL TEMPERATURE**
SELEKTIVE GESTELLKÜHLUNG BASIEREND AUF DER AUSSENTEMPERATUR
REFROIDISSEMENT DE BÂTI SÉLECTIF BASÉ SUR LA TEMPÉRATURE EXTÉRIEURE

(30) Priority: 07.02.2020 CN 202010082577
(43) Date of publication of application: 11.08.2021
(73) Proprietor: Schneider Electric IT Corporation, Foxboro, MA 02035 (US)
(72) Inventor: CHEN, Jun, Shanghai, Shanghai 201803 (CN); WANG, Jian, Dongcheng Beijing, Beijing 100013 (CN); ZHU, Guanglin, Shanghai, Shanghai 201203 (CN); DU, Jie, Shanghai, Shanghai 201203 (CN)
(74) Representative: Murgitroyd & Company

(56) References cited:
- US-A1- 2006 026 978
- US-A1- 2012 100 794
- US-A1- 2014 064 916

## Description

### RELATED APPLICATIONS

This application claims the benefit of Chinese Patent Application Serial No. 202010082577.7, titled "Selective Rack Cooling Based on External Temperature," filed February 7, 2020.

### BACKGROUND

Power consumption is a significant cost of operating computer systems, including rackmounted equipment. End users, information technology (IT) providers, and equipment rack vendors often look for ways to improve power usage effectiveness (PUE), in order to reduce total cost of ownership (TCO). Because electronics can generate considerable heat, a significant portion of the power consumption is due to cooling equipment. Air conditioners are one source of significant power consumption.

Approaches described in this section have not necessarily been conceived and/or pursued prior to the filing of this application. Accordingly, unless otherwise indicated, approaches described in this section should not be construed as prior art. Documents US2014/064916 and US2012/100794 disclose examples of methods and systems for controlling power consumption according to available prior art.

### SUMMARY

One or more embodiments improve PUE by selectively cooling inside a rack enclosure based on the external temperature, *i.e.,* the temperature outside the rack enclosure. Specifically, based on the external temperature, one or more embodiments select among different power configurations for cooling components. In some power configurations, one or more fans provide(s) cooling from external air, thus reducing the cooling burden on an air conditioner inside the rack enclosure. In some power configurations, the air conditioner can be powered off. In general, fans consume less power than air conditioners. Thus, one or more embodiments improve PUE, in comparison to techniques that use an air conditioner full-time and do not take advantage of cooling from external air. Reduced power usage may translate to a significant reduction in TCO.

In general, in one aspect there is a computer implemented method according to claim 1. An equipment rack is provided according to claim 4. The operations may further include, when the power status of the air conditioner is on, controlling an intensity of air conditioning to manage a temperature inside the rack enclosure. Controlling the intensity of air conditioning may be performed by the air conditioner, based at least on a reading from a temperature sensor disposed within the rack enclosure. The operations include: receiving temperature and humidity inside the rack enclosure from a temperature and humidity sensor configured to sense the temperature and humidity inside the rack enclosure; and controlling operation of the air conditioner disposed within the rack enclosure, based at least on the temperature and humidity inside the rack enclosure. Controlling the power status of the at least one fan may include controlling power statuses of at least two groups of intake and exhaust fans. The at least one fan may include an exhaust fan and the temperature sensor is disposed near the exhaust fan.

In general, in a non-claimed example, a controller is configured to perform operations including:
receiving a temperature outside a rack enclosure from a temperature sensor configured to sense the temperature outside the rack enclosure; and controlling (a) a power status of at least one fan configured to provide airflow through the rack enclosure and (b) a power status of an air conditioner disposed within the rack enclosure, based at least on the temperature outside the rack enclosure. Controlling the power status of the at least one fan and the power status of the air conditioner disposed within the rack enclosure, based at least on the temperature outside the rack enclosure, may include comparing the temperature outside the rack enclosure with at least one threshold temperature value. The at least one threshold temperature value may include an upper threshold temperature value and a lower threshold temperature value. When the temperature outside the rack enclosure is in an upper range, the power status of the at least one fan may be off and the power status of the air conditioner disposed within the rack enclosure may be on. When the temperature outside the rack enclosure is in a middle range, the power status of the at least one fan may be on and the power status of the air conditioner may be on. When the temperature outside the rack enclosure is in a lower range, the power status of the at least one fan may be on and the power status of the air conditioner may be off. The operations may further include, when the power status of the air conditioner is on, controlling an intensity of air conditioning to manage a temperature inside the rack enclosure. Controlling the intensity of air conditioning may be performed by the air conditioner, based at least on a reading from a temperature sensor disposed within the rack enclosure. The operations may further include: receiving temperature and humidity inside the rack enclosure from a temperature and humidity sensor configured to sense the temperature and humidity inside the rack enclosure; and controlling operation of the air conditioner disposed within the rack enclosure, based at least on the temperature and humidity inside the rack enclosure. Controlling the power status of the at least one fan may include controlling power statuses of at least two groups of intake and exhaust fans. The at least one fan may include an exhaust fan and the temperature sensor is disposed near the exhaust fan.

In general, in one aspect, a system is provided according to claim 5.

The operations may further include, when the power status of the air conditioner is on, controlling an intensity of air conditioning to manage a temperature inside the rack enclosure. Controlling the intensity of air conditioning may be performed by the air conditioner, based at least on a reading from a temperature sensor disposed within the enclosure. The operations include: receiving temperature and humidity inside the enclosure from a temperature and humidity sensor configured to sense the temperature and humidity inside the enclosure; and controlling operation of the air conditioner disposed within the enclosure, based at least on the temperature and humidity inside the enclosure. Controlling the power status of the at least one fan may include controlling power statuses of at least two groups of intake and exhaust fans. The at least one fan may include an intake fan and the temperature sensor configured to sense the temperature outside the enclosure may be disposed near the intake fan.

One or more embodiments described in this Specification and/or recited in the claims may not be included in this General Overview section.

### BRIEF DESCRIPTION OF THE DRAWINGS

Various aspects of at least one embodiment are discussed below with reference to the accompanying Figures, which are not intended to be drawn to scale. The Figures are included to provide illustration and a further understanding of the various aspects and embodiments, and are incorporated in and constitute a part of this specification, but are not intended to define the limits of the disclosure. In the Figures, each identical or nearly identical component that is illustrated in various Figures is represented by a like numeral. For the purposes of clarity, some components may not be labeled in every figure. In the Figures:
FIG. 1A is a block diagram of an example of an equipment rack according to an embodiment;
FIG. 1B is a block diagram of an example of an electrical layout for the equipment rack of FIG. 1A according to an embodiment;
FIG. 2 illustrates an example of an equipment rack according to an embodiment;
FIG. 3 is a flow diagram of an example of operations for selective rack cooling based on external temperature, according to an embodiment;
FIG. 4 is a flow diagram of an example of operations for controlling fan and air conditioner power statuses based on external temperature, according to an embodiment; and
FIG. 5 is a block diagram of an example of a computer system according to an embodiment.

### DETAILED DESCRIPTION

The phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items. References to "or" may be construed as inclusive so that any terms described using "or" may indicate any of a single, more than one, and all of the described terms.

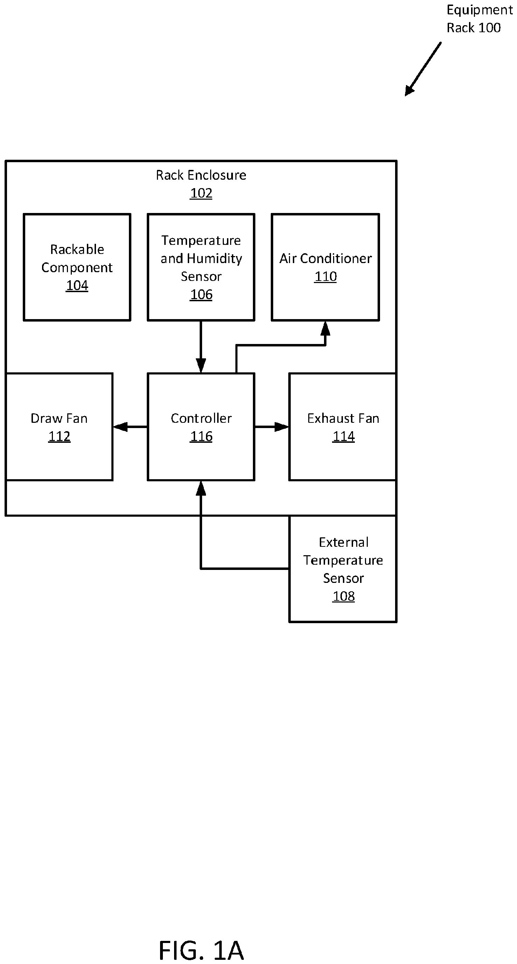

FIG. 1A is a block diagram of an example of an equipment rack 100 according to an embodiment. In an embodiment, the equipment rack 100 may include more or fewer components than the components illustrated in FIG. 1A. Components illustrated in FIG. 1A may be local to or remote from each other. Components illustrated in FIG. 1A may be implemented in software and/or hardware. Each component may be distributed over multiple applications and/or machines. Multiple components may be combined into one application and/or machine. Operations described with respect to one component may instead be performed by another component. In the following discussion, examples are given with reference to a rack enclosure. In view of the present disclosure, those skilled in the art will appreciate that one or more embodiments may relate to any kind of enclosure for electrical equipment.

In an embodiment, an equipment rack 100 refers to an apparatus configured to house one or more rackable components 104. Specifically, the equipment rack 100 includes a rack enclosure 102 that is designed to house a rackable component 104 that is sized according to an industry-wide standard, such as one or more standards defined by the Electronic Industries Alliance (EIA) (*e.g.,* EIA-310), European Telecommunications Standards Institute (ETSI) (*e.g.,* ETSI 300 119), the Open Compute Project (OCP), or another standardizing organization. For example, the rack enclosure 102 may be a 19-inch or 23-inch 42U enclosure, a 19-inch or 23-inch 24U enclosure, or another size of enclosure. A rackable component 104 may be a 1U unit, 2U unit, 3U unit, 4U unit, or other size of unit. A rackable component 104 may be a half-rack component. Alternatively, the rack enclosure 102 and rackable component 104 may have proprietary sizes that do not conform to any industry-wide standard. Different rackable components 104 in the same rack enclosure 102 may have different sizes. In an embodiment, the equipment rack 100 is a 24U micro-datacenter, such as those manufactured by Schneider Electric SE. The equipment rack 100 may be configured to house many different kinds of rackable components 104. For example, a rackable component 104 may be a server, telecommunications equipment, networking hardware, audiovisual equipment, scientific equipment, and/or another kind of equipment or combination thereof.

In an embodiment, the equipment rack 100 includes components configured to sense the temperatures inside and outside the rack enclosure 102. The equipment rack 100 may also include one or more components configured to sense the humidity inside the rack enclosure 102. A temperature and humidity sensor 106 may be configured to sense the temperature and humidity inside the rack enclosure 102. Alternatively, an internal temperature sensor (not shown) may be configured to sense only the temperature inside the rack enclosure, without sensing humidity. A humidity sensor (not shown) may be configured to sense only the humidity inside the rack enclosure, without sensing the temperature. The temperature and humidity sensor 106 may be part of the controller 116, part of the air conditioner 110, part of another component, or a separate component operatively coupled with one or more other components in the rack enclosure 102. An external temperature sensor 108 is configured to sense the temperature outside *(i.e.,* physically external to) the rack enclosure 102. For example, the external temperature sensor 108 may be mounted to, or otherwise coupled with, an outside-facing surface of the rack enclosure 102, in order to sense the temperature physically proximate to the rack enclosure 102.

In an embodiment, a controller 116 refers to hardware and/or software configured to perform operations described herein for selective rack cooling based on the temperature outside the rack enclosure 102, *i.e.,* based on data from the external temperature sensor 108. Specifically, the controller 116 is configured to selectively control the power statuses of an air conditioner 110 and one or more fans *(e.g.,* one or more draw fans 112 configured to draw air into the rack enclosure 102 and/or one or more exhaust fans 114 configured to expel air from the rack enclosure 102), based on the external temperature. When the air conditioner 110 is powered on, the controller 116 may also be configured to control operation of the air conditioner 110 (*i.e.,* control an intensity of air conditioning performed by the air conditioner 110), for example, by transmitting temperature and/or humidity setpoints to the air conditioner 110. Alternatively or additionally, the rack enclosure 102 may include a proportional-integral-derivative (PID) controller (not shown) configured to control operation of the air conditioner 110, when the air conditioner 110 is powered on, to reach a temperature setpoint and/or humidity setpoint. Specifically, the PID controller may determine an intensity of air conditioning performed by the air conditioner 110. The PID controller may be part of the controller 116, part of the air conditioner 110, part of another component, or a separate component operatively coupled with one or more other components in the rack enclosure 102 *(e.g.,* the air conditioner 110).

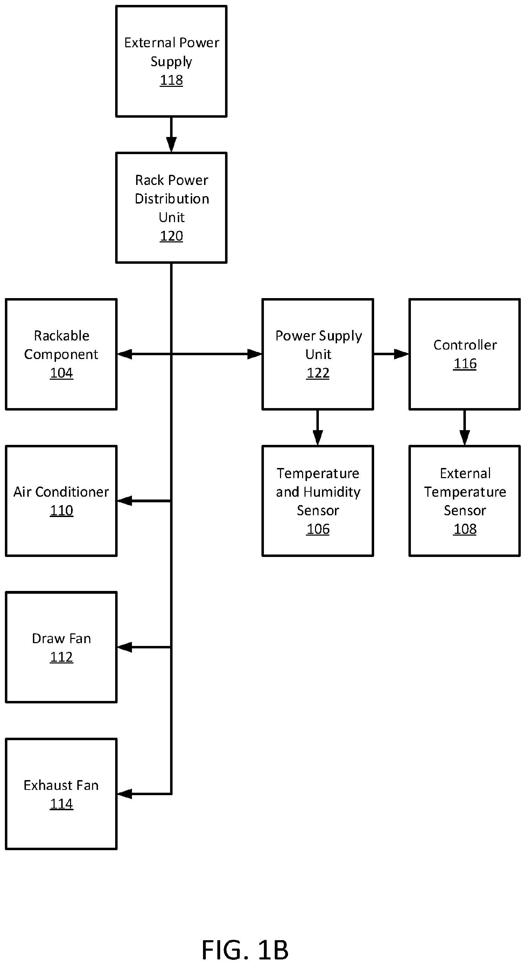

FIG. 1B is a block diagram of an example of an electrical layout for the equipment rack 100 of FIG. 1A according to an embodiment. The electrical layout illustrated in FIG. 1B is provided as an example only and should not be construed as limiting one or more embodiments. In an embodiment, an external power supply 118 refers to a power supply that is external to the equipment rack 100. For example, the external power supply 118 may be a power utility, an uninterruptible power supply (UPS), or another kind of external power source. A rack power distribution unit 120 is configured to receive power from the external power supply 118 and distribute power to electrical components of the equipment rack 100. In this example, the rack power distribution unit 120 distributes power to the rackable component 104, air conditioner 110, draw fan 112, exhaust fan 114, and power supply unit 122. The rack power distribution unit 120 may also be configured to monitor power used by components of the equipment rack 100, detect circuit overloads, and/or perform other operations to manage power supplied to components of the equipment rack 100. For example, the rack power distribution unit 120 may be a NetShelter Power Distribution Unit (PDU) manufactured by Schneider Electric SE. The power supply unit 122 is configured to convert alternating current (AC) to direct current (DC), for use by components that require direct current. For example, the power supply unit 122 may be a 24 volts direct current power supply unit (24VDC PSU) or another kind of unit. In this example, the power supply unit 122 supplies direct current to the controller 116 and the temperature and humidity sensor 106. In this example, the external temperature sensor 108 requires no more than 5 volts, which the controller 116 can provide, while the power supply unit 122 is configured to supply 24 volts. Therefore, in this example, the controller 116 is configured to supply power to the external temperature sensor 108.

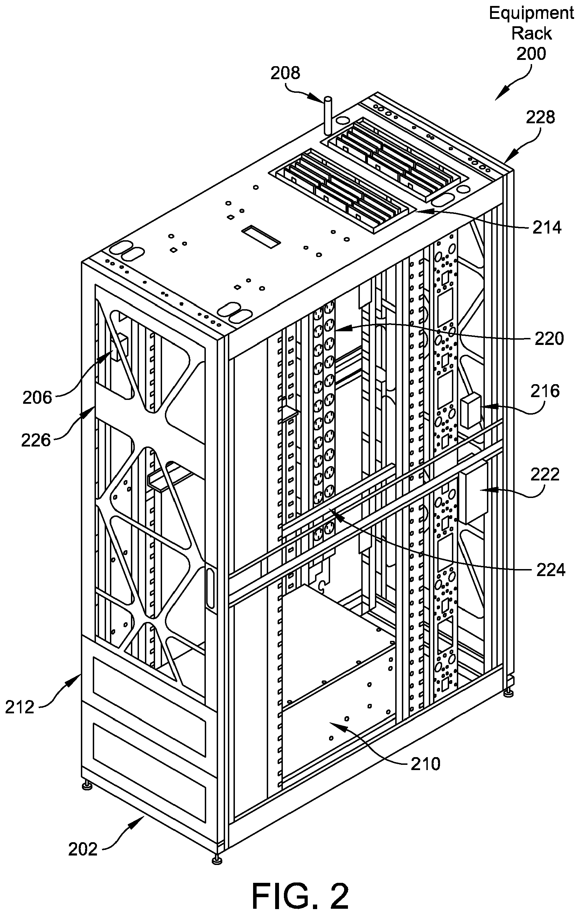

FIG. 2 illustrates an example of an equipment rack 200 according to an embodiment. The equipment rack 200 includes a rack enclosure 202 configured to house one or more rack components (not shown). Specifically, the rack enclosure 202 includes one or more sets of rails 224 configured to accommodate rack components at particular locations within the rack enclosure 202. The inside of the rack enclosure 202 is accessible (*e.g*., to install or remove components) via a front door 226 and a back door 228. In this example, the front door 226 and back door 228 are formed at least partly of glass, for visibility into the rack enclosure 202 while helping keep dust out of the rack enclosure 202. A rack power distribution unit 220 is configured to receive power from an external power source (not shown) and distribute power to components of the equipment rack 200. A power supply unit 222 is configured to convert alternating current to direct current, for components that require direct current.

As illustrated in FIG. 2, the equipment rack 200 includes various cooling components. Specifically, the equipment rack 200 includes an air conditioner 210 disposed inside the rack enclosure 202, and two groups of front draw fans 212 and top exhaust fans 214 that are configured to circulate air through the rack enclosure 202. Other examples (not shown) may use a different number of fans and/or fan groups. A controller 216 is configured to control the power statuses of the air conditioner 210 and fans 212, 214, based on data from an external temperature sensor 208. In this example, the external temperature sensor 208 is located on an outside-facing surface of the rack enclosure 202, adjacent to the exhaust fans 214. Alternatively, the external temperature sensor 208 may be located adjacent to the front draw fans 212 (or one or more draw fans in another location), to sense the temperature of air that will be drawn into the rack enclosure 202. In addition, a temperature and humidity sensor 206 disposed inside the rack enclosure 202 is configured to sense the temperature and humidity inside the rack enclosure 202. In Figure 2, the temperature and humidity sensor 206 is shown as a separate component. Alternatively, the temperature and humidity sensor 206 may be part of the controller 216, part of the air conditioner 210, or part of another component. A PID controller, which in this example is part of the air conditioner 210 (but may alternatively be part of the controller 216, part of another component, or a separate component), is configured to control operation of the air conditioner 210 *(i.e.,* an intensity of air conditioning), when the air conditioner 210 is powered on, based on temperature and humidity data from the temperature and humidity sensor 206.

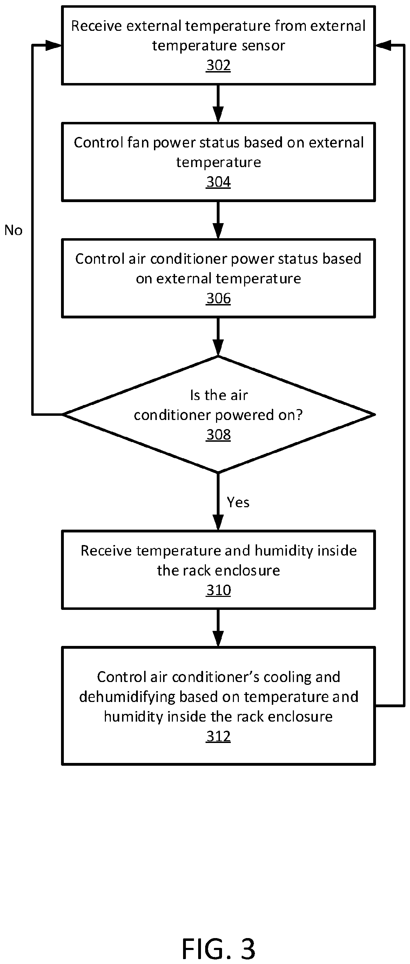

FIG. 3 is a flow diagram of an example of operations for selective rack cooling based on external temperature, according to an embodiment. One or more operations illustrated in FIG. 3 may be modified, rearranged, or omitted all together. Accordingly, the particular sequence of operations illustrated in FIG. 3 should not be construed as limiting the scope of one or more embodiments.

In the following discussion, the term "controller" may refer to multiple controllers. Specifically, different controller operations described herein may be performed by a single controller or divided between two or more controllers. For example, one controller may be configured to control power statuses of an air conditioner and fan(s), while a separate controller *(e.g.,* a PID controller that is part of the air conditioner or another component) may be configured to control an intensity of air conditioning.

In an embodiment, selective rack cooling based on external temperature relies on the general observation that fans consume less power than air conditioners. In addition, external air (*i.e.,* air that is outside of the rack enclosure) may be cold enough to help cool components inside the rack enclosure. Whether the external air is cold enough may depend, for example, on factors such as the season, weather, cooling provided by a building that houses the equipment rack, *etc.* The external temperature may vary over time. Accordingly, one or more embodiments use the external temperature to determine when to use an air conditioner and when to use fan cooling to take advantage of cold external air.

In an embodiment, a controller in an equipment rack receives an external temperature from an external temperature sensor (Operation 302). Based on the external temperature, the controller controls the power statuses of one or more fans (Operation 304) and an air conditioner (Operation 306). Specifically, based on the external temperature, the controller may determine whether the fan(s) alone should be powered on, the air conditioner alone should be powered on, or both the fan(s) and the air conditioner should be powered on. As used in this context, the terms "powered on" and "powered off' refer to whether the fan(s) and/or air conditioner are actively providing cooling capabilities and may not indicate a complete lack of power supplied to the fan(s) and/or the air conditioner. Some power may still be supplied to a fan or air conditioner that is "powered off." For example, a fan that is "powered off" may still receive some power even though it is not rotating, and an air conditioner that is "powered off" may still receive some power even though it is not cooling the air inside the rack enclosure.

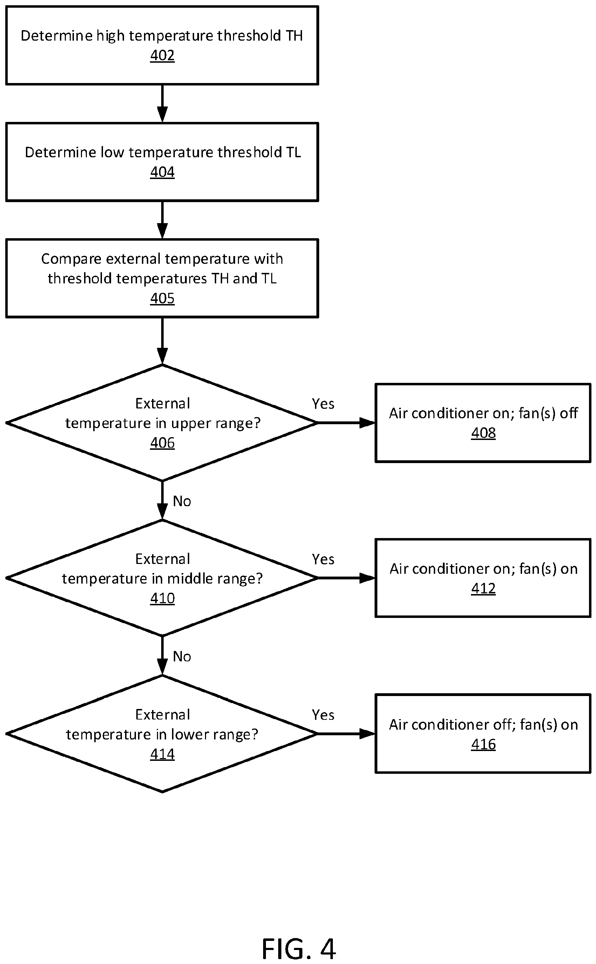

FIG. 4 is a flow diagram of an example of operations for controlling fan and air conditioner power statuses based on external temperature (*i.e.,* Operations 304 and 306 of FIG. 3), according to an embodiment. One or more operations illustrated in FIG. 4 may be modified, rearranged, or omitted all together. For example, while FIG. 4 illustrates an external temperature being compared to an upper range, middle range, and lower range, such comparisons may be performed in a different order. In addition, as discussed below, more or fewer temperature thresholds and/or ranges may be used. Accordingly, the particular sequence of operations illustrated in FIG. 4 should not be construed as limiting the scope of one or more embodiments.

In an embodiment, the controller determines a high temperature threshold, abbreviated here as "TH" (Operation 402). TH defines the lower boundary of an upper range of external temperatures, above which the air conditioner should be powered on and the fan(s) should be powered off. TH may be inclusive, *i.e.,* the air conditioner should be powered on and the fan(s) should be powered off when the external temperature is greater than or equal to TH. Alternatively, TH may be exclusive, *i.e.,* the air conditioner should be powered on and the fan(s) should be powered off when the external temperature is greater than TH. The upper range of temperatures may not have an upper limit. TH may be hard-coded into the controller's logical components *(i.e.,* hardware and/or software). Alternatively, TH may be configurable, for example via a user interface that is configured to receive user input to configure cooling parameters of the equipment rack.

In an embodiment, the controller determines a low temperature threshold, abbreviated here as "TL" (Operation 404). TL defines the upper boundary of a lower range of external temperatures, below which the air conditioner should be powered off and the fan(s) should be powered on. TL may be inclusive, *i.e.,* the air conditioner should be powered off and the fans should be powered on when the external temperature is less than or equal to TL. Alternatively, TL may be exclusive, *i.e.,* the air conditioner should be turned off and the fans should be powered on when the external temperature is less than TL. The lower range of temperatures may not have a lower limit. TL may be hard-coded into the controller's logical components (*i.e.,* hardware and/or software). Alternatively, TL may be configurable, for example via a user interface that is configured to receive user input to configure cooling parameters of the equipment rack.

In an embodiment, the controller compares the external temperature with the threshold temperatures TH and TL (Operation 405). Based on the comparison, the controller determines the power statuses of the fan(s) and air conditioner, and sets the power statuses accordingly via one or more electrical signals. If a fan or air conditioner is already in the appropriate power status, then the controller may not transmit an electrical signal to that component. The controller may track the current power statuses of the fan(s) and air conditioner (*e.g*., in one or more software variables, one or more hardware registers, and/or one or more other locations) and transmit an electric signal only when a change in power status is needed.

In an embodiment, if the external temperature is in the upper range (Decision 406), then the controller powers on the air conditioner and power off the fan(s) (Operation 408). When the external temperature is in the upper range, the external air is not cold enough to help with cooling. Accordingly, this configuration of power statuses avoids drawing in air from the external environment into the rack enclosure, while cooling the rack enclosure using the air conditioner. Because this power configuration relies entirely on the air conditioner, it uses more power than configurations that are able to also provide cooling from external air. Therefore, one or more embodiments can reduce power consumption by using this power configuration only when needed, *i.e.,* when the external temperature is in the upper range.

In an embodiment, if the external temperature is in a middle range, *i.e*., between the upper range and the lower range (Decision 410), then the controller powers on the air conditioner and powers on the fan(s) (Operation 412). When the external temperature is in the middle range, the external air is cold enough to help with cooling, but not cold enough to provide all the cooling needed. Accordingly, this configuration of power statuses uses the fan(s) to provide cooling from external air, while also using the air conditioner to supply additional cooling. Because the external air is cold enough to partially alleviate the cooling burden placed on the air conditioner, one or more embodiments can reduce power consumption when the external temperature is in the middle range, in comparison to relying exclusively on the air conditioner.

In an embodiment, if the external temperature is in the lower range (Decision 414), then the controller powers off the air conditioner and powers on the fan(s) (Operation 416). In the lower range of external temperatures, the external air provided by the fan(s) is cold enough to provide all the cooling needed, and the air conditioner is not needed. Therefore, one or more embodiments can reduce power consumption when the external temperature is in the lower range, by taking advantage of cold external air and powering off the air conditioner.

While the example illustrated in FIG. 4 uses two threshold temperatures, one or more embodiments may use more than two threshold temperatures. For example, a rack enclosure may include multiple air conditioners. The controller may use multiple tiers of middle ranges to determine which and/or how many of the air conditioners to power on, with more air conditioners being powered on at higher temperatures. As another example, an air conditioner may have multiple power settings corresponding to different cooling intensities. The controller may use multiple tiers of middle ranges to determine which air conditioner power setting to use, with higher-intensity settings used at higher temperatures. Alternatively, the controller may use only a single threshold temperature, defining an upper range and an external range. For example, when the external temperature is in the upper range, the controller may power on the air conditioner and power off the fan(s). When the external temperature is in the lower range, the controller may power off the air conditioner and power on the fan(s), or power on both the air conditioner and the fan(s). Embodiments should not be considered limited to the particular thresholds and ranges illustrated in FIG. 4.

Returning to FIG. 3, in power configurations where the air conditioner is powered on (*e.g.,* the upper and middle ranges of external temperatures, in the example illustrated in FIG. 4), a controller (*e.g*., the same controller used to control power statuses and/or a separate PID controller) may control operation of the air conditioner (*i.e.,* an intensity of air conditioning). In an embodiment, the controller determines whether the air conditioner is currently powered on (Decision 308). In addition, the controller receives the temperature and humidity inside the rack enclosure (Operation 310), *e.g.,* from a temperature and humidity sensor as discussed above. The controller may receive the temperature and humidity on an ongoing basis, whether or not the air conditioner is powered on. Alternatively, the controller may receive the temperature and humidity only when the air conditioner is powered on. In an embodiment, the controller controls the air conditioner's cooling and dehumidifying based on the temperature and humidity inside the rack enclosure (Operation 312). For example, the controller may use one or more feedback loops to control the intensities of cooling and dehumidifying, based on temperature and humidity setpoints. In other examples, the controller may control only the intensity of cooling, or only the intensity of dehumidifying.

In an embodiment, the controller continues to receive the external temperature (Operation 302) on an ongoing basis (for example, at regular intervals and/or when requested by the controller) and adjusts the power statuses of the fan(s) and air conditioner as external temperature conditions change over time. Thus, one or more embodiments help ensure that the air conditioner is used only when needed, relying more on the fan(s) to reduce power consumption when the external temperature is sufficiently cold.

In an embodiment, a system includes one or more devices, including one or more hardware processors, that are configured to perform any of the operations described herein and/or recited in any of the claims.

In an embodiment, one or more non-transitory computer-readable storage media store instructions that, when executed by one or more hardware processors, cause performance of any of the operations described herein and/or recited in any of the claims.

Any combination of the features and functionalities described herein may be used in accordance with an embodiment. In the foregoing specification, embodiments have been described with reference to numerous specific details that may vary from implementation to implementation. Accordingly, the specification and figures are to be regarded in an illustrative rather than a restrictive sense. The sole and exclusive indicator of the scope of the invention, and what is intended by the Applicant to be the scope of the invention, is the literal and equivalent scope of the set of claims that issue from this application, in the specific form in which such claims issue, including any subsequent correction.

In an embodiment, techniques described herein are implemented by one or more special-purpose computing devices *(i.e.,* computing devices specially configured to perform certain functionality). The special-purpose computing device(s) may be hard-wired to perform the techniques and/or may include digital electronic devices such as one or more application-specific integrated circuits (ASICs), field programmable gate arrays (FPGAs), and/or network processing units (NPUs) that are persistently programmed to perform the techniques. Alternatively or additionally, a computing device may include one or more general-purpose hardware processors programmed to perform the techniques pursuant to program instructions in firmware, memory, and/or other storage. Alternatively or additionally, a special-purpose computing device may combine custom hard-wired logic, ASICs, FPGAs, or NPUs with custom programming to accomplish the techniques. A special-purpose computing device may include a desktop computer system, portable computer system, handheld device, networking device, and/or any other device(s) incorporating hard-wired and/or program logic to implement the techniques.

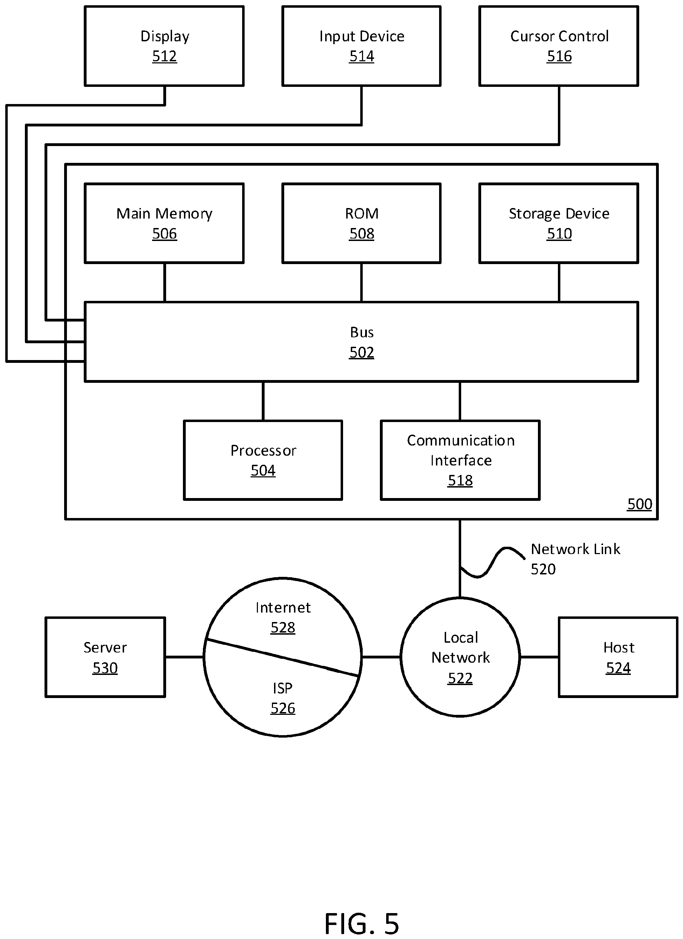

For example, FIG. 5 is a block diagram of an example of a computer system 500 according to an embodiment. Computer system 500 includes a bus 502 or other communication mechanism for communicating information, and a hardware processor 504 coupled with the bus 502 for processing information. Hardware processor 504 may be a general-purpose microprocessor.

Computer system 500 also includes a main memory 506, such as a random access memory (RAM) or other dynamic storage device, coupled to bus 502 for storing information and instructions to be executed by processor 504. Main memory 506 also may be used for storing temporary variables or other intermediate information during execution of instructions to be executed by processor 504. Such instructions, when stored in one or more non-transitory storage media accessible to processor 504, render computer system 500 into a special-purpose machine that is customized to perform the operations specified in the instructions.

Computer system 500 further includes a read only memory (ROM) 508 or other static storage device coupled to bus 502 for storing static information and instructions for processor 504. A storage device 510, such as a magnetic disk or optical disk, is provided and coupled to bus 502 for storing information and instructions.

Computer system 500 may be coupled via bus 502 to a display 512, such as a liquid crystal display (LCD), plasma display, electronic ink display, cathode ray tube (CRT) monitor, or any other kind of device for displaying information to a computer user. An input device 514, including alphanumeric and other keys, may be coupled to bus 502 for communicating information and command selections to processor 504. Alternatively or additionally, computer system 500 may receive user input via a cursor control 516, such as a mouse, a trackball, a trackpad, or cursor direction keys for communicating direction information and command selections to processor 504 and for controlling cursor movement on display 512. This input device typically has two degrees of freedom in two axes, a first axis *(e.g.,* x) and a second axis *(e.g.,* y), that allows the device to specify positions in a plane. Alternatively or additionally, computer system 500 may include a touchscreen. Display 512 may be configured to receive user input via one or more pressure-sensitive sensors, multi-touch sensors, and/or gesture sensors. Alternatively or additionally, computer system 500 may receive user input via a microphone, video camera, and/or some other kind of user input device (not shown).

Computer system 500 may implement the techniques described herein using customized hard-wired logic, one or more ASICs or FPGAs, firmware, and/or program logic which in combination with other components of computer system 500 causes or programs computer system 500 to be a special-purpose machine. According to one embodiment, the techniques herein are performed by computer system 500 in response to processor 504 executing one or more sequences of one or more instructions contained in main memory 506. Such instructions may be read into main memory 506 from another storage medium, such as storage device 510. Execution of the sequences of instructions contained in main memory 506 causes processor 504 to perform the process steps described herein. Alternatively or additionally, hard-wired circuitry may be used in place of or in combination with software instructions.

The term "storage media" as used herein refers to one or more non-transitory media storing data and/or instructions that cause a machine to operate in a specific fashion. Such storage media may comprise non-volatile media and/or volatile media. Non-volatile media includes, for example, optical or magnetic disks, such as storage device 510. Volatile media includes dynamic memory, such as main memory 506. Common forms of storage media include, for example, a floppy disk, a flexible disk, hard disk, solid state drive, magnetic tape or other magnetic data storage medium, a CD-ROM or any other optical data storage medium, any physical medium with patterns of holes, a RAM, a programmable read-only memory (PROM), an erasable PROM (EPROM), a FLASH-EPROM, non-volatile random-access memory (NVRAM), any other memory chip or cartridge, content-addressable memory (CAM), and ternary content-addressable memory (TCAM).

A storage medium is distinct from but may be used in conjunction with a transmission medium. Transmission media participate in transferring information between storage media. Examples of transmission media include coaxial cables, copper wire, and fiber optics, including the wires that comprise bus 502. Transmission media may also take the form of acoustic or light waves, such as those generated during radio-wave and infra-red data communications.

Various forms of media may be involved in carrying one or more sequences of one or more instructions to processor 504 for execution. For example, the instructions may initially be carried on a magnetic disk or solid state drive of a remote computer. The remote computer may load the instructions into its dynamic memory and send the instructions over a network, via a network interface controller (NIC), such as an Ethernet controller or Wi-Fi controller. A NIC local to computer system 500 may receive the data from the network and place the data on bus 502. Bus 502 carries the data to main memory 506, from which processor 504 retrieves and executes the instructions. The instructions received by main memory 506 may optionally be stored on storage device 510 either before or after execution by processor 504.

Computer system 500 also includes a communication interface 518 coupled to bus 502. Communication interface 518 provides a two-way data communication coupling to a network link 520 that is connected to a local network 522. For example, communication interface 518 may be an integrated services digital network (ISDN) card, cable modem, satellite modem, or a modem to provide a data communication connection to a corresponding type of telephone line. As another example, communication interface 518 may be a local area network (LAN) card to provide a data communication connection to a compatible LAN. Wireless links may also be implemented. In any such implementation, communication interface 518 sends and receives electrical, electromagnetic or optical signals that carry digital data streams representing various types of information.

Network link 520 typically provides data communication through one or more networks to other data devices. For example, network link 520 may provide a connection through local network 522 to a host computer 524 or to data equipment operated by an Internet Service Provider (ISP) 526. ISP 526 in turn provides data communication services through the world wide packet data communication network now commonly referred to as the "Internet" 528. Local network 522 and Internet 528 both use electrical, electromagnetic or optical signals that carry digital data streams. The signals through the various networks and the signals on network link 520 and through communication interface 518, which carry the digital data to and from computer system 500, are example forms of transmission media.

Computer system 500 can send messages and receive data, including program code, through the network(s), network link 520 and communication interface 518. In the Internet example, a server 530 might transmit a requested code for an application program through Internet 528, ISP 526, local network 522, and communication interface 518.

The received code may be executed by processor 504 as it is received, and/or stored in storage device 510, or other non-volatile storage for later execution.

Having thus described several aspects of at least one embodiment, it is to be appreciated that various alterations, modifications, and improvements will readily occur to those skilled in the art. Such alterations, modifications, and improvements are intended to be part of this disclosure and are intended to be within the scope of the invention. Accordingly, the foregoing description and drawings are by way of example only, and the scope of the invention should be determined from proper construction of the appended claims, and their equivalents.

## Claims

1. A computer implemented method, when run on a controller, comprising the steps of:
determining an upper threshold temperature;
determining a lower threshold temperature;
receiving a temperature outside a rack enclosure (102) from a temperature sensor configured to sense the temperature outside the rack enclosure;
when the temperature outside the rack enclosure is greater than or equal/greater than said upper threshold temperature powering on an air conditioner (110) disposed within the rack enclosure and powering off at least one fan (112, 114) configured to provide airflow through the rack enclosure, and
when the temperature outside the rack enclosure is less than or equal/less than said lower threshold temperature powering off the air conditioner, and powering on the at least one fan; and **characterised by** comprising the steps of:
receiving temperature and humidity inside the rack enclosure from a temperature and humidity sensor (106) configured to sense the temperature and humidity inside the rack enclosure; and
controlling operation of the air conditioner disposed within the rack enclosure, based at least on the temperature and humidity inside the rack enclosure.

2. The method of claim 1, wherein powering on or off the at least one fan and the air conditioner disposed within the rack enclosure, based at least on the temperature outside the rack enclosure, comprises comparing the temperature outside the rack enclosure with the upper threshold temperature value and the lower threshold temperature value.

3. The method of claim 1, wherein:
when the temperature outside the rack enclosure is above the upper threshold temperature, the at least one fan is powered off and the air conditioner disposed within the rack enclosure is powered on;
when the temperature outside the rack enclosure is between the upper threshold temperature and lower threshold temperature, the at least one fan is powered on and the air conditioner is powered on; and
when the temperature outside the rack enclosure is below the lower threshold temperature, the at least one fan is powered on and the air conditioner is powered off.

4. An equipment rack comprising:
a rack enclosure (102);
at least one fan (112, 114) configured to provide airflow through the rack enclosure;
an air conditioner (110) disposed within the rack enclosure; and
a controller (116) configured to receive a temperature outside of the rack enclosure from a temperature sensor (108) and configured to receive temperature and humidity inside the rack enclosure from a temperature and humidity sensor (106), the controller configured to perform the method of any claims 1-3.

5. A system comprising:
an air conditioner (110) configured to be disposed within a rack enclosure (102) for electrical equipment;
at least one fan (112, 114) configured to provide airflow through the rack enclosure:
a temperature sensor (108) configured to sense a temperature outside the enclosure;
a temperature and humidity sensor (106) configured to sense the temperature and humidity inside the enclosure; and
a controller (116) configured to perform the method of any claims 1-3.

6. A computer program comprising computer executable instructions adapted to perform the method of any claims 1-3, when executed on a controller of the equipement rack as defined in claim 4 or on the controller of the system as defined in claim 5.

7. A non-transitory computer-readable medium containing the computer program of claim 6.

## Patentansprüche

1. Ein computerimplementiertes Verfahren, das, wenn es auf einer Steuerung laufen gelassen wird, die folgenden Schritte beinhaltet:
Bestimmen einer oberen Schwellenwerttemperatur;
Bestimmen einer unteren Schwellenwerttemperatur;
Empfangen einer Temperatur außerhalb einer Gestelleinhausung (102) von einem Temperatursensor, der konfiguriert ist, um die Temperatur außerhalb der Gestelleinhausung zu erfassen;
wenn die Temperatur außerhalb der Gestelleinhausung größer als oder gleich/größer als die obere Schwellenwerttemperatur ist, Einschalten einer Klimaanlage (110), die innerhalb der Gestelleinhausung angeordnet ist, und Ausschalten mindestens eines Gebläses (112, 114), das konfiguriert ist, um einen Luftstrom durch die Gestelleinhausung bereitzustellen, und
wenn die Temperatur außerhalb der Gestelleinhausung kleiner als oder gleich/kleiner als die untere Schwellenwerttemperatur ist, Ausschalten der Klimaanlage und
Einschalten des mindestens einen Gebläses; und **gekennzeichnet durch** Beinhalten der folgenden Schritte:
Empfangen der Temperatur und Feuchtigkeit innerhalb der Gestelleinhausung von einem Temperatur- und Feuchtigkeitssensor (106), der konfiguriert ist, um die Temperatur und Feuchtigkeit innerhalb der Gestelleinhausung zu erfassen; und
Steuern des Betriebs der innerhalb der Gestelleinhausung angeordneten Klimaanlage auf der Grundlage zumindest der Temperatur und der Feuchtigkeit innerhalb der Gestelleinhausung.

2. Verfahren gemäß Anspruch 1, wobei das Ein- bzw. Ausschalten des mindestens einen Gebläses und der innerhalb der Gestelleinhausung angeordneten Klimaanlage auf der Grundlage zumindest der Temperatur außerhalb der Gestelleinhausung das Vergleichen der Temperatur außerhalb der Gestelleinhausung mit dem oberen Schwellenwerttemperaturwert und dem unteren Schwellenwerttemperaturwert beinhaltet.

3. Verfahren gemäß Anspruch 1, wobei:
wenn die Temperatur außerhalb der Gestelleinhausung über der oberen Schwellenwerttemperatur liegt, das mindestens eine Gebläse ausgeschaltet wird und die innerhalb der Gestelleinhausung angeordnete Klimaanlage eingeschaltet wird;
wenn die Temperatur außerhalb der Gestelleinhausung zwischen der oberen Schwellenwerttemperatur und der unteren Schwellenwerttemperaturliegt, das mindestens eine Gebläse eingeschaltet wird und die Klimaanlage eingeschaltet wird; und
wenn die Temperatur außerhalb der Gestelleinhausung unter der unteren Schwellenwerttemperatur liegt, das mindestens eine Gebläse eingeschaltet wird und die Klimaanlage ausgeschaltet wird.

4. Ein Gerätegestell, beinhaltend:
eine Gestelleinhausung (102);
mindestens ein Gebläse (112, 114), das konfiguriert ist, um einen Luftstrom durch die Gestelleinhausung bereitzustellen;
eine Klimaanlage (110), die innerhalb der Gestelleinhausung angeordnet ist; und
eine Steuerung (116), die konfiguriert ist, um eine Temperatur außerhalb der Gestelleinhausung von einem Temperatursensor (108) zu empfangen, und konfiguriert ist, um eine Temperatur und Feuchtigkeit innerhalb der Gestelleinhausung von einem Temperatur- und Feuchtigkeitssensor (106) zu empfangen, wobei die Steuerung konfiguriert ist, um das Verfahren gemäß einem der Ansprüche 1-3 durchzuführen.

5. Ein System, beinhaltend:
eine Klimaanlage (110), die konfiguriert ist, um innerhalb einer Gestelleinhausung (102) für elektrische Ausrüstung angeordnet zu sein;
mindestens ein Gebläse (112, 114), das konfiguriert ist, um einen Luftstrom durch die Gestelleinhausung bereitzustellen;
einen Temperatursensor (108), der konfiguriert ist, um eine Temperatur außerhalb der Einhausung zu erfassen;
einen Temperatur- und Feuchtigkeitssensor (106), der konfiguriert ist, um die Temperatur und Feuchtigkeit innerhalb der Einhausung zu erfassen; und
eine Steuerung (116), die konfiguriert ist, um das Verfahren gemäß einem der Ansprüche 1-3 durchzuführen.

6. Ein Computerprogramm, das computerausführbare Anweisungen beinhaltet, die angepasst sind, um das Verfahren gemäß einem der Ansprüche 1-3 durchzuführen, wenn es auf einer Steuerung des Ausrüstungsgestells wie in Anspruch 4 definiert oder auf der Steuerung des Systems wie in Anspruch 5 definiert ausgeführt wird.

7. Ein nichttransitorisches computerlesbares Medium, das das Computerprogramm gemäß Anspruch 6 enthält.

## Revendications

1. Un procédé mis en oeuvre par ordinateur, lorsqu'il est exploité sur un contrôleur, comprenant les étapes consistant à :
déterminer une température seuil supérieure ;
déterminer une température seuil inférieure ;
recevoir une température à l'extérieur d'une enceinte de bâti (102) en provenance d'un capteur de température configuré pour capter la température à l'extérieur de l'enceinte de bâti ;
lorsque la température à l'extérieur de l'enceinte de bâti est plus grande que ou égale à/plus grande que ladite température seuil supérieure, mettre sous tension un appareil de climatisation (110) disposé au sein de l'enceinte de bâti et mettre hors tension au moins un ventilateur (112, 114) configuré pour fournir un écoulement d'air à travers l'enceinte de bâti, et
lorsque la température à l'extérieur de l'enceinte de bâti est plus petite que ou égale à/plus petite que ladite température seuil inférieure, mettre hors tension l'appareil de climatisation, et mettre sous tension l'au moins un ventilateur ; et **caractérisé par** le fait de comprendre les étapes consistant à :
recevoir la température et l'humidité à l'intérieur de l'enceinte de bâti en provenance d'un capteur de température et d'humidité (106) configuré pour capter la température et l'humidité à l'intérieur de l'enceinte de bâti ; et
contrôler le fonctionnement de l'appareil de climatisation disposé au sein de l'enceinte de bâti, sur la base au moins de la température et de l'humidité à l'intérieur de l'enceinte de bâti.

2. Le procédé de la revendication 1, dans lequel la mise sous tension ou hors tension de l'au moins un ventilateur et de l'appareil de climatisation disposé au sein de l'enceinte de bâti, sur la base au moins de la température à l'extérieur de l'enceinte de bâti, comprend la comparaison de la température à l'extérieur de l'enceinte de bâti avec la valeur de température seuil supérieure et la valeur de température seuil inférieure.

3. Le procédé de la revendication 1, dans lequel :
lorsque la température à l'extérieur de l'enceinte de bâti est au-dessus de la température seuil supérieure, l'au moins un ventilateur est mis hors tension et l'appareil de climatisation disposé au sein de l'enceinte de bâti est mis sous tension ;
lorsque la température à l'extérieur de l'enceinte de bâti est comprise entre la température seuil supérieure et la température seuil inférieure, l'au moins un ventilateur est mis sous tension et l'appareil de climatisation est mis sous tension ; et
lorsque la température à l'extérieur de l'enceinte de bâti est en dessous de la température seuil inférieure, l'au moins un ventilateur est mis sous tension et l'appareil de climatisation est mis hors tension.

4. Un bâti d'équipement comprenant :
une enceinte de bâti (102) ;
au moins un ventilateur (112, 114) configuré pour fournir un écoulement d'air à travers l'enceinte de bâti ;
un appareil de climatisation (110) disposé au sein de l'enceinte de bâti ; et
un contrôleur (116) configuré pour recevoir une température à l'extérieur de l'enceinte de bâti en provenance d'un capteur de température (108) et configuré pour recevoir la température et l'humidité à l'intérieur de l'enceinte de bâti en provenance d'un capteur de température et d'humidité (106), le contrôleur étant configuré pour réaliser le procédé de n'importe quelles revendications 1 à 3.

5. Un système comprenant :
un appareil de climatisation (110) configuré pour être disposé au sein d'une enceinte de bâti (102) pour un équipement électrique ;
au moins un ventilateur (112, 114) configuré pour fournir un écoulement d'air à travers l'enceinte de bâti ;
un capteur de température (108) configuré pour capter une température à l'extérieur de l'enceinte ;
un capteur de température et d'humidité (106) configuré pour capter la température et l'humidité à l'intérieur de l'enceinte ; et
un contrôleur (116) configuré pour réaliser le procédé de n'importe quelles revendications 1 à 3.

6. Un programme d'ordinateur comprenant des instructions exécutables par ordinateur conçues pour réaliser le procédé de n'importe quelles revendications 1 à 3, lorsqu'elles sont exécutées sur un contrôleur du bâti d'équipement tel que défini dans la revendication 4 ou sur le contrôleur du système tel que défini dans la revendication 5.

7. Un support non transitoire lisible par ordinateur contenant le programme d'ordinateur de la revendication 6.
